## Europäisches Patentamt

## European Patent Office

## Office européen des brevets

(11) Veröffentlichungsnummer: **0 398 159**
**A1**

## EUROPÄISCHE PATENTANMELDUNG

(21) Anmeldenummer: **90108833.6**

(22) Anmeldetag: **10.05.90**

(51) Int. Cl.5: **H01P 1/185, H03C 7/02**

(30) Priorität: **19.05.89 EP 89109087**

(43) Veröffentlichungstag der Anmeldung:
**22.11.90 Patentblatt 90/47**

(84) Benannte Vertragsstaaten:
**CH DE DK GB IT LI NL**

(71) Anmelder: **Siemens Aktiengesellschaft**
**Wittelsbacherplatz 2**
**D-8000 München 2(DE)**

(72) Erfinder: **Müller, Dietmar, Dipl.-Ing.**
**Viktoria Strasse 50**
**D-5300 Bonn 2(DE)**

(54) **Endlosphasenschieber.**

(57) Ein Endlosphasenschieber für den Radio-Frequenzbereich ermöglicht das phasenrichtige Addieren zweier RF-Signale.

Der Endlosphasenschieber ist in Schlitz-und Streifenleitungstechnik realisiert in der Weise, daß für die Phasendrehung das zu drehende RF-Signal durch einen Lange-Koppler ($K_1$) in zwei um $90°$ versetzte Signale aufgetrennt und die so entstandenen Signalkomponenten (x- und y-Signale) über eine beschaltete Schlitzleitungsanordnung mit zwei gleichstrommäßig antiparallel geschalteten Halbleiterelementen, z. B. PIN-Dioden ($Dx_1, Dx_2; Dy_1, Dy_2$), um $0°$ bzw. $180°$ gedreht werden. Die beiden Signalkomponenten werden dann mittels eines 3dB-Kopplers mit $0°$ Phasendrehung (Wilkinson-Koppler) ($K_2$) addiert.

FIG 1

EP 0 398 159 A1

Die Erfindung bezieht sich auf einen Endlosphasenschieber für den Radio-Frequenzbereich.

Im Frequenzgebiet um 100 MHz werden kontinuierlich einstellbare Phasenschieber im allgemeinen aus 90°-Kopplern mit 3dB Koppeldämpfung und Kapazitätsdioden aufgebaut. Ein solcher Phasenschieber ist beispielsweise durch den Aufsatz "Miniaturized 90° Couplers by Using Lumped Elements" von Osamu Unui bekannt, erschienen in NEC Research and Development (1981) 63, S. 50 - 53.

Aus der US-PS 4 056 792 ist ein Diodengeschaltetes Mikrowellen-Phasenschiebenetzwerk bekannt, daß aus mehreren Stufen mit jeweils zwei parallelen Pfaden besteht. In jeweils einem Pfad der einzelnen Stufen ist ein Leitungsabschnitt bestimmter elektrischer Länge (180°, 90°) für die Phasenschiebung angeordnet.

Der Erfindung liegt die Aufgabe zugrunde, eine Einrichtung zu schaffen zum phasenrichtigen Addieren zweier RF-Signale mit Hilfe eines Phasenschiebers im RF-Weg eines Empfangsmischers.

Diese Aufgabe wird mit einem Endlosphasenschieber gelöst, der in Schlitz- und Streifenleitungstechnik realisiert ist in der Weise, daß das zu drehende RF-Signal durch einen 3dB-Koppler in zwei um 90° versetzte Signalkomponenten (x-Signalweg und y-Signalweg) aufgetrennt wird, daß die beiden Signalkomponenten jeweils über eine beschaltete Schlitzleiteranordnung, bestehend aus einem die signalführende Streifenleitung im Abstand von ihrem λ/4-Leerlauf rechtwinklig kreuzenden Schlitzleitungsabschnitt mit einer an einem Endbereich vorgesehenen, einen Leerlauf transformierenden Leitungsstruktur und einer sich am anderen Endbereich anschließenden zweimal λ/4-langen kreisförmigen Schlitzleitung und der Anordnung von zwei gleichstrommäßig antiparallel geschalteten Halbleiterelementen mit stromabhängigem HF-Widerstand an der Übergangsstelle des Schlitzleitungsabschnitts zu der kreisförmigen Schlitzleitung, um 0° bzw. 180° gedreht werden, und daß eine diese kreisförmige Schlitzleitung im Abstand von λ/4 zu den Dioden rechtwinklig kreuzende Streifenleitung zur Auskopplung des Signals angeordnet ist und diese Streifenleitungen für die beiden Signalkomponenten über einen zweiten 3dB-Koppler mit 0° Phasendrehung zusammengeführt werden.

Vorteilhafte Ausgestaltungen und Weiterbildungen des Erfindungsgegenstandes sind in den Unteransprüchen angegeben.

Nachstehend wird die Erfindung anhand eines in der Zeichnung dargestellten Ausführungsbeispiels näher erläutert.

Es zeigen

Fig. 1 Die Gesamtanordnung eines Endlosphasenschiebers,

Fig. 2 in einer Teildarstellung den Pfad einer Signalkomponente und

Fig. 3 den Signalverlauf in Polardarstellung.

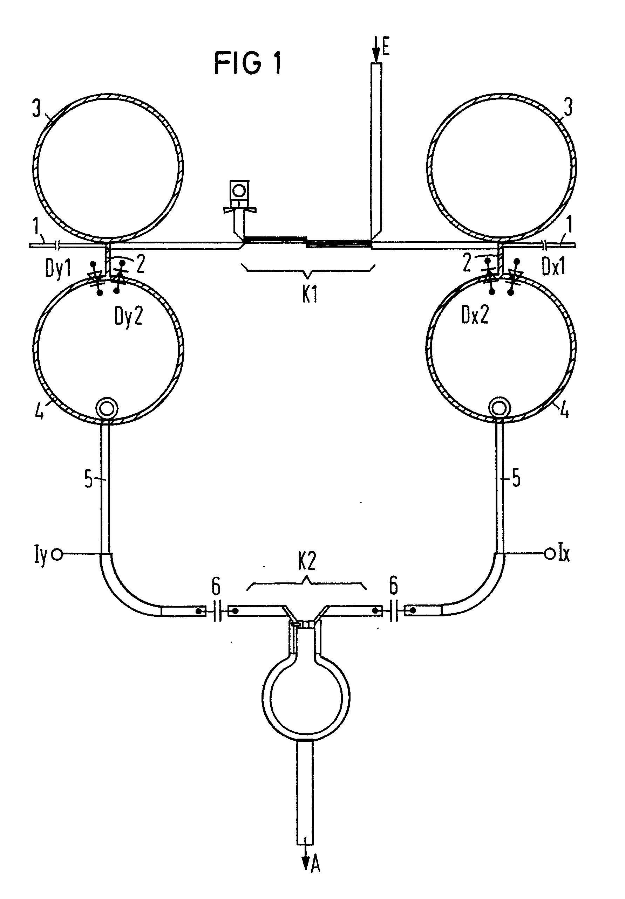

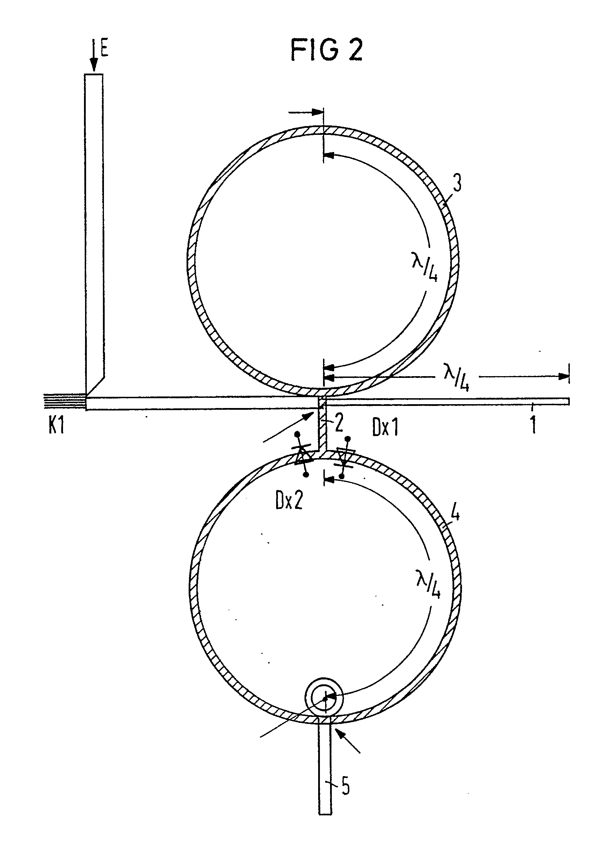

Für das phasenrichtige Addieren zweier RF-Signale wird ein Signal als phasenstarr angenommen und das zweite Signal in der Phasenlage so verändert, daß die Phasendifferenz Null ist. In Figur 1 ist die Schaltungsanordnung eines in Schlitz- und Streifenleitungstechnik realisierten Endlosphasenschiebers dargestellt, in dem das zu drehende RF-Signal einer entsprechenden Verarbeitung unterzogen wird. Die Leiterbahnen der Streifenleitung und die Schlitzleitungen sind dabei auf den einander gegenüberliegenden Seiten eines Substrats angeordnet. Das am Eingang E zugeführte RF-Signal gelangt zunächst auf einen 3dB-Koppler K1 mit 90° Phasenverschiebung (Lange-Koppler) und wird in zwei um 90° versetzte Signale aufgetrennt (x-Signalweg und y-Signalweg). Die so entstandenen x- und y-Signale werden über eine beschaltete Schlitzleitungsanordnung um 0° bzw. 180° gedreht. Dies ist in Figur 2 näher gezeigt, in der der x-Signalweg in einer Detaildarstellung vergrößert wiedergegeben ist. Der y-Signalweg verhält sich entsprechend.

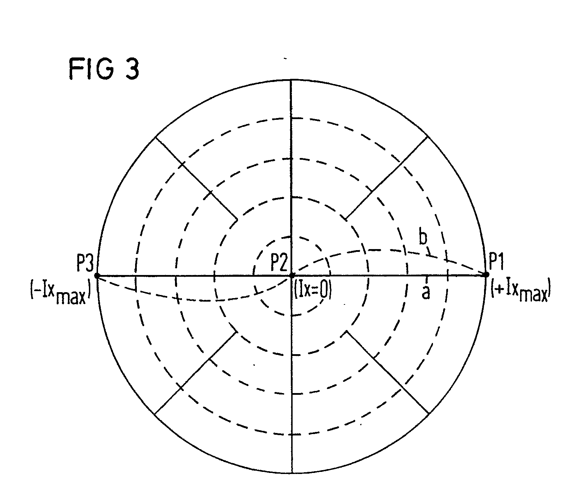

Ausgehend vom Koppler K1 ist im x-Signalweg eine wellenwiderstandsrichtig angepaßte Streifenleitung 1 vorgesehen, zu der im Abstand λ/4 zum Leerlauf ein diese senkrecht kreuzender Schlitzleitungsabschnitt 2 auf der gegenüberliegenden Substratseite (in der Darstellung unten liegenden Seite) angeordnet ist. Die Einkopplung des HF-Signals geschieht bei der Streifenleitung durch λ/4-Transformation des Leerlaufes in einen Kurzschluß und bei der Schlitzleitung durch die λ/4-Transformation eines virtuellen Kurzschlusses in einen Leerlauf. Der virtuelle Kurzschluß ist bei der dargestellten Ausführungsform als kreisförmige Schlitzleitung 3 von zweimal λ/4 Länge ausgebildet, die sich an einem Ende des Schlitzleitungsabschnittes 2 anschließt. Eine ebenfalls kreisförmige Schlitzleitung 4 von zweimal λ/4 Länge ist am anderen Ende des Schlitzleitungsabschnittes 2 angeordnet. An der Übergangsstelle von Schlitzleitungsabschnitt 2 zur kreisförmigen Schlitzleitung 4 ist beiderseits über der Schlitzleitung 4 jeweils ein Halbleiterelement Dx1, Dx2 angeordnet, die gleichstrommäßig antiparallel geschaltet sind und deren HF-Widerstand sich mit angelegtem Strom ändert. Mittels dieser beiden, beispielsweise als PIN-Dioden ausgebildeten Halbleiterelemente Dx1, Dx2 wird das Signal so beeinflußt, daß über die Schlitzleiteranordnung kontinuierlich u. a. die Punkte P1, P2, P3 in der Polardarstellung gemäß Figur 3 erreicht werden, die auf der waagerechten Achse liegen und für positiven maximalen Diodengleichstrom, den Diodengleichstrom 0 und für negativen maximalen Diodengleichstrom gelten. Die für die einzelnen Punkte geltenden Bedingungen sind nachfolgend zusammengestellt:

P1: der steuernde Diodengleichstrom ist + Imax

($R_{Dx2}$ = $R_D$min; $R_{Dx1}$ = $R_D$max)

P2: der steuernde Diodengleichstrom ist 0

($R_{Dx1}$ = $R_{Dx2}$ = $R_D$max)

P3: der steuernde Diodengleichstrom ist - Imax

($R_{Dx1}$ = $R_D$min ; $R_{Dx2}$ = $R_D$max).

Wie die graphische Darstellung in Figur 3 zeigt, besitzt der reale Verlauf (strichlierte Kurveb mit etwa sinusförmigen Verlauf) eine Abweichung vom Ideal (Gerade a), bedingt durch den Wellenwiderstand der Schlitzleiteranordnung und parasitäre Elemente der PIN-Dioden. Durch die Realisierung eines großen Wellenwiderstandes in der Schlitzleitung wird die Abweichung vom Ideal verringert.

Die Auskopplung des HF-Signals an dem dem Diodenstandort gegenüberliegenden Bereich der Schlitzleitung 4 geschieht durch die $\lambda$/4-Transformation des E-Feldes, das an den PIN-Dioden an liegt, in die Streifenleitungsebene, wobei eine die Schlitzleitung 4 im Auskoppelbereich senkrecht kreuzende Streifenleitung 5 direkt, also ohne die $\lambda$/4-Transformation eines Leerlaufes, kurzgeschlossen wird. Dies hat den Vorteil, daß der eingespeiste Diodenstrom direkt über die Streifenleitung zugeführt werden kann (vergl. die Stromzuführung Ix und Iy an die Streifenleitung 5 in Fig. 1).

Für I = 0 ($R_{D1}$ = $R_{D2}$ = $R_D$max) liegt am Auskoppelpunkt - von jeder Schlitzleitungsseite her - die gleiche HF-Amplitude, aber mit unterschiedlichen· Vorzeichen, an. Dadurch wird, wie am Eingang der Schlitzleitungsanordnung ein virtueller Kurzschluß erzeugt und am Ausgang eine HF-Entkopplung erzielt.

Die beiden Signalkomponenten des x-Signalweges und y-Signalweges werden über einen 3dB-Koppler K2 mit der Phasenverschiebung 0° (Wilkinson-Koppler) addiert, wobei jeder Punkt innerhalb des in Figur 3 dargestellten Kreises durch zwei eingeprägte x- und y-Ströme einstellbar ist. Im Weg der zum Koppler K2 führenden Streifenleitungen 5 ist jeweils eine DC-Sperre 6 eingefügt. Der Ausgang des Endlosphasenschiebers ist mit A bezeichnet. Die Schaltung ist reziprok, so daß Eingang und Ausgang vertauscht werden können.

Der vorstehend beschriebene Phasenschieber hat eine vielfältige Anwendung. Neben dem Einsatz im Empfangsteil einer Richtfunkan lage kann er auch dazu dienen, aus einem Sendesignal zwei Komponenten mit einstellbarer Phasenlage zu erzeugen. Mit dieser Schaltung können auch beliebige Digital- bzw. Analog-Signale direkt in die RF-Ebene moduliert werden. Außer der Verwendung als RF-Modulator ist aber auch die Verwendung der Schlitzleiteranordnung als Dämpfungsglied möglich. Schließlich können mit Teilen dieser Schaltung auch Leistungen aufgeteilt und in gewünschter Weise verändert werden.

## Ansprüche

1. Endlosphasenschieber für den Radio-Frequenzbereich, **gekennzeichnet durch** seine Realisierung in Schlitz- und Streifenleitungstechnik in der Weise, daß das zu drehende RF-Signal durch einen 3dB-Koppler in zwei um 90° versetzte Signalkomponenten (x-Signalweg und y-Signalweg) aufgetrennt wird, daß die beiden Signalkomponenten jeweils über eine beschaltete Schlitzleiteranordnung, bestehend aus einem die signalführende Streifenleitung im Abstand von ihrem $\lambda$/4-Leerlauf rechtwinklig kreuzenden Schlitzleitungsabschnitt mit einer an einem Endbereich vorgesehenen, einen Leerlauf transformierenden Leitungsstruktur und einer sich am anderen Endbereich anschließenden zweimal $\lambda$/4-langen kreisförmigen Schlitzleitung und der Anordnung von zwei gleichstrommäßig antiparallel geschalteten Halbleiterelementen mit stromabhängigem MF-Widerstand an der Übergangsstelle des Schlitzleitungsabschnitts zu der kreisförmigen Schlitzleitung, um 0° bzw. 180° gedreht werden, und daß eine diese kreisförmige Schlitzleitung im Abstand von $\lambda$/4 zu den Dioden rechtwinklig kreuzende Streifenleitung zur Auskopplung des Signals angeordnet ist und diese Streifenleitungen für die beiden Signalkomponenten über einen zweiten 3dB-Koppler mit 0° Phasendrehung zusammengeführt werden.

2. Endlosphasenschieber nach Anpruch 1, **dadurch gekennzeichnet,** daß die einen Leerlauf transformierende Leitungsstruktur aus einer zweimal $\lambda$/4-langen kreisförmigen Schlitzleitung besteht.

3. Endlosphasenschieber nach Anspruch 1 oder 2, **dadurch gekennzeichnet,** daß zwischen den beiden Streifenleitungen für die Signalkomponenten und die beiden Eingänge des zweiten 3dB-Kopplers jeweils eine Gleichstrom-Sperre eingeschaltet ist.

4. Endlosphasenschieber nach einem der Ansprüche 1 bis 3, **dadurch gekennzeichnet,** daß die Halbleiterelemente aus PIN-Dioden bestehen.

5. Endlosphasenschieber nach einem der Ansprüche 1 bis 4, **gekennzeichnet durch** seine Verwendung als RF-Modulator, dessen Modulationspunkte in der x-y-Ebene einstellbar sind.

6. Endlosphasenschieber nach einem der Ansprüche 1 bis 4, **gekennzeichnet durch** die Verwendung der Schlitzleiteranordnung als Dämpfungsglied.

# FIG 1

# FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 276 521 (DAVIDHEISER) <br> * Spalte 3, Zeile 43 - Spalte 5, Zeile 59; Figuren 2,3 * | 1,5 | H 01 P 1/185 <br> H 03 C 7/02 |
| Y | | 3,4,6 | |
| Y | IEEE TRANSACTIONS ON MICROWAVE THEORY AND TECHNIQUES, Band MTT-32, Nr. 12, Dezember 1984, Seiten 1551-1556, IEEE, New York, US; H. OGAWA et al.: "A 26-GHz High-performance MIC transmitter/receiver for digital radio subscriber systems" <br> * Figur 2 * | 3 | |
| Y | NACHRICHTENTECHNISCHE BERICHTE, Heft 4, Mai 1987, Seiten 48-56, Backnang, DE; W. BISCHOF et al.: "Baugruppen für den Mikrowellen- und Millimeterwellenbereich" <br> * Seite 52, Zeilen 3-40; Figur 9 * | 4 | |
| Y | CONFERENCE - PROCEEDINGS OF THE 5TH EUROPEAN MICROWAVE CONFERENCE, Hamburg, 1.-4. September 1975, Seiten 128-132, Microwave Exhibitions and Publishers Ltd, Kent, GB; S. REHNMARK: "Wideband planar transmission lin pin-diode attenuator/modulator" <br> * Seite 128, Zeilen 21-26; Figur 1 * | 6 | **RECHERCHIERTE SACHGEBIETE (Int. Cl.5)** <br><br> H 01 P <br> H 03 C <br> H 03 D <br> H 04 L |
| X | PATENT ABSTRACTS OF JAPAN, Band 10, Nr. 317 (E-449)[2373], 28. Oktober 1986; & JP-A-61 128 601 (MITSUBISHI ELECTRIC CORP.) 16-06-1986 <br> * Insgesamt *      -/- | 1 | |

Der vorliegende Recherchenbericht wurde für alle Patentansprüche erstellt

| Recherchenort | Abschlußdatum der Recherche | Prüfer |
|---|---|---|
| DEN HAAG | 31-07-1990 | DEN OTTER A.M. |

**Europäisches Patentamt**

# EUROPÄISCHER RECHERCHENBERICHT

Nummer der Anmeldung

EP 90 10 8833

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|-----------|------------|------|------|
| A | IEEE TRANSACTIONS ON MICROWAVE THEORY AND TECHNIQUES, Band 37, Nr. 2, Februar 1989, Seiten 406-413, IEEE, New York, US; M. AIKAWA et al.: "Double-sided MIC's and their applications" * Seite 408, linke Spalte, Zeile 16 - rechte Spalte, Zeile 14; Seite 410, rechte Spalte, Zeilen 1-15; Figuren 5,6,13(a) * | 2 | |

RECHERCHIERTE SACHGEBIETE (Int. Cl.5)

Der vorliegende Recherchenbericht wurde für alle Patentansprüche erstellt

| Recherchenort | Abschlußdatum der Recherche | Prüfer |
|---------------|------------|--------|
| DEN HAAG | 31-07-1990 | DEN OTTER A.M. |

EPO FORM 1503 03.82 (P0403)